# EUROPEAN PATENT SPECIFICATION

(11) **EP 3 580 813 B1**
(45) Date of publication and mention of the grant of the patent: **30.10.2024**
(21) Application number: 18703772.6
(22) Date of filing: 06.02.2018
(51) Int. Cl.: H01Q 1/22, H01Q 9/04, H01Q 23/00

(54) **PATCH ANTENNA**
PATCH-ANTENNE
ANTENNE À PLAQUE

(30) Priority: 08.02.2017 NO 20170194
(43) Date of publication of application: 18.12.2019
(73) Proprietor: Norbit Its, 7440 Trondheim (NO)
(72) Inventor: KIRKNES, Steffen, 7055 Ranheim (NO)
(74) Representative: Bryn Aarflot AS
(86) International application number: PCT/EP2018/052925
(87) International publication number: WO 2018/146085

(56) References cited:
- EP-A1- 3 059 803
- US-A1- 2013 181 874
- US-A1- 2016 261 036
- MAURICIO SANCHEZ-BARBETTY ET AL: "Compact, Low-Cost, Surface-Mount Active Antenna", IEEE ANTENNAS AND WIRELESS PROPAGATION LETTERS, IEEE, PISCATAWAY, NJ, US, vol. 9, 1 January 2010 (2010-01-01), pages 1255 - 1258, XP011344061, ISSN: 1536-1225, DOI: 10.1109/LAWP.2011.2104935

## Description

The present teachings relate generally to antennas. More specifically, the present teachings relate to patch antennas for receiving and/or transmitting an electromagnetic signal preferably in microwave range.

Radio frequency ("RF") apparatuses such as transponders usually include a patch antenna. A patch antenna primarily consists of a flat sheet of metal, more simply called a patch, arranged over a larger sheet of metal, called a ground plane. In case of microwave circuits, at least some of the associated circuitry needs to be mounted on a substrate that has suitable properties, such as low loss. Such substrates suitable for microwave applications, or more simply called microwave substrates, are generally expensive. The related feed network and circuitry usually requires a microwave substrate for achieving required performance. Usually the feed network and the related circuitry is placed on the ground plane side of the substrate. Even though the rest of the circuitry, besides the microwave circuitry, might not require a special substrate, or microwave substrate, the complexity and cost of adding yet another low-cost/low-performance substrate for the rest of the circuitry does not necessarily pay off. As a result, the overall cost of the apparatus is increased.

US2004032368A1 teaches a miniaturized circularly polarized SDS patch antenna, but it does not address the requirements related to the related circuitry.

US2016261036 describes an antenna arrangement including a patch antenna with corresponding microwave circuitry positioned relative to a ground plane using substrates being positioned directly on top of each other. Similar devices are described in the article Mauricio Sanchez-Barbetty et al; "Compact, Low-Cost, Surface-Mount Active Antenna", IEEE Antennas and Wireless Propagation Letters, IEEE, PISCATAWAY, NJ, US, , vol.9, 1 January 2010, pages 1255-1258, ISSN; 1536-1225, DOI: 10.1109/LAMP.2011.2104935 as well as in EP3059803 and US2013181874.

The above-mentioned and other problems inherent to the prior art will be shown solved by the features of the accompanying independent claim.

According to an object of the present teachings a patch antenna arrangement that allows utilization of a low cost substrate for the ground-plane can be provided.

According to further an object of the present teachings an integrated patch antenna can be provided.

The present teachings will now be discussed more in detail using the following drawings illustrating the aspects of the teachings by way of examples. The figures are not necessarily drawn to scale, without affecting the scope of the invention as defined in the claims.
- Fig. 1: illustrates a conventional patch antenna.
- Fig. 2: illustrates an aspect of the teachings by showing an antenna arrangement with microwave circuitry facing the ground plane.
- Fig. 3: illustrates another aspect of the present teachings when microwave circuitry is placed facing away from the ground plane.

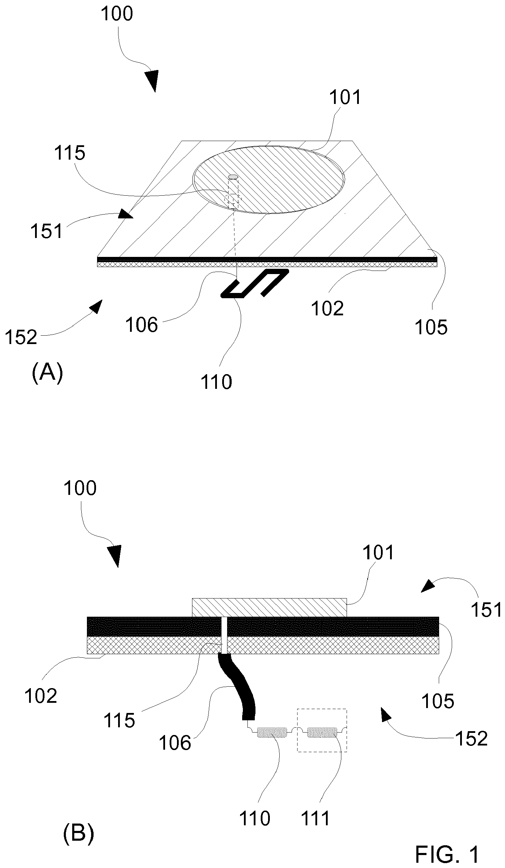

Fig. 1 shows a perspective view (A) and a side view (B) of a conventional patch antenna arrangement 100. The antenna arrangement 100 comprises a patch antenna 101 placed upon the top-side 151 of a substrate 105. On the bottom-side 152 of the substrate 105, a ground plane 102 is placed. The patch antenna 101 and the ground plane 102 are usually realized in metal. The patch 101 is designed to electrically resonate at a desired frequency over the ground plane 102. On the bottom-side 152 of the substrate 105, circuitry is placed. The circuitry includes microwave circuitry 110, that includes components such as feed network and circuits that require a special substrate, but the circuitry can also include other circuits and components 111 that do not require a special, or microwave, substrate. The microwave circuitry is connected through a feedline 106, and thereafter to a probe type feed 115 for electrically connecting to the patch antenna 101. The positioning of the feed 115 normally defines the impedance. The impedance is typically 50 ohm, but it can be designed for other values as well as per requirements. Even though the feedline 106 can be realized as a microstrip in the same metal layer as the ground plane (not explicitly shown in the figures), it may not be desirable to alter or disrupt the integrity of the ground plane 102. A person skilled in the art will understand that alternatives to this are possible, for example, isolated bridges, or other kinds of isolated tracks, or another dielectric layer, or even another substrate.

Due to requirements set by the microwave circuitry, the substrate 105 is a microwave substrate. Even though the rest of the circuitry 111 besides the microwave circuitry 110 might not require a special substrate or microwave substrate 105 for functioning adequately, the complexity and cost of adding yet another low-cost/low-performance substrate for the rest of the circuitry 111 does not necessarily pay off, as a result the other circuitry 111 is also sharing and occupying area on the same expensive substrate 105.

In an alternative arrangement (not shown in figures), the patch 101 is not in direct contact with the microwave substrate 105. In this case the patch 101 may be separated from the microwave substrate 105 either by an airgap or by another dielectric substrate (not shown in figures). The ground plane can thus in this case be formed on the top-side 151 of the substrate, whilst the microwave circuitry 110 and the other circuitry 111 can still be placed on the bottom side 152 of the substrate 105. An advantage of doing this is that either both 110 and 111, or at least the microwave circuitry 110 may be placed directly underneath the patch 101 with a minimal disturbance or disruption in the integrity of the ground plane, which in this case will be formed in the metal layer on the top-side 151 of the microwave substrate 105. However, in this case also, adding an alternative low-cost/low-performance substrate for the rest of the circuitry 111 is not necessarily worth. Since the required microwave properties of the substrate 105 may mean that low cost, e.g., FR4 type, laminates cannot be used, more expensive microwave substrates have be used not only for the entire circuitry but also for the ground plane 102.

In many applications, the area of the ground plane 102 needs to be at least twice the area of the patch antenna 101, so this means that a microwave substrate at least as large as the area of the ground plane may be required.

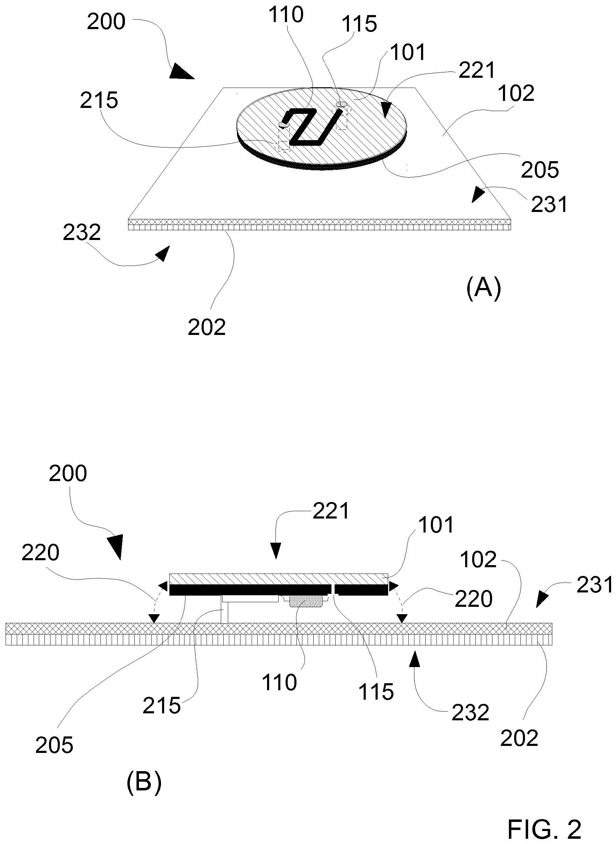

Fig. 2 shows an arrangement 200 according a first aspect of the present teachings. Fig. 2 illustrates a perspective view (A) and a side view (B) of the antenna arrangement 200. In this case, the patch antenna 101 is arranged on the top-side 221 of a first substrate 205. On the bottom-side of the first substrate 205, substrate sensitive circuitry or microwave circuitry 110 is placed or mounted. The combination of essentially; the patch antenna 101, the first substrate 205, and the microwave circuitry 110 is termed herein as a "patch antenna group".

The microwave circuitry 110 is operably in electrical coupling with the patch antenna 101 through a first feed 115 that traverses vertically through, or is a via in, the first substrate 205. Alternatively the first feed 115 may also contact the antenna 101 from a vertical conductive path placed at a desired location on the periphery or edge of the first substrate 205 (alternative case not shown in the figures).

The antenna arrangement 200 also comprises a second feed 215. The second feed 215 can be used, for example, for feeding low frequency signals such as supply voltages and baseband signals to the patch antenna group. Said signals are preferably fed at a "cold" point or spot of the patch 101. In the shape of the patch antenna 101 shown, a location essentially at the center of the patch 101 is known to be such a "cold" spot, i.e., it typically displays a minimum microwave signal voltage. The example illustrated in Fig. 2 however does not show the second feed 215 contacting at the center of the patch antenna 101, even though it is usually preferable to place the second feed at a cold spot.

Fig. 2 further shows a ground plane 102 that is arranged on the top-side 231 of a second substrate 202. Fig. 2 (B) also shows some field lines 220 between the patch antenna 101 and the ground plane 102.The second feed 215 is in contact with the same conductive layer (typically a metal layer) that the ground plane 102 is realized in, however the second feed 215 is electrically isolated from the ground plane. The same metal layer on the top-side 231 of the second substrate 202 can also be used to pattern and route any additional circuitry, for example 111 (not shown in Fig. 2).

The second feed may also be acting as a mechanical support for the patch antenna group as shown arranged above the top-side 231 of the second substrate 202. This is especially the case if the spacing between the patch antenna group and the ground plane 102 as shown in Fig. 2 is an air-gap. There could also be other mechanical supports for mechanically supporting the patch antenna group. These other mechanical supports may or may not be electrically conductive. In case they are electrically conductive, they may also be used for feeding low-frequency or DC signals between the patch antenna group and the other circuitry, for example, 111 (not shown in Fig. 2).

The bottom-side 232 of the second substrate 202 is shown empty or unpatterned in Fig. 2, but it may include another metal layer if required. Alternatively, or in addition, the additional circuitry may be mounted and or routed on the bottom-side 232 of the second substrate 202. In this case, the bottom side 232 will also have a conductive layer, or a metal layer for routing and mounting of the additional circuitry.

As a general note, as commented previously, the figures are not essentially to scale, some features sizes may even be disproportionately enlarged with respect to other parts shown in the figures, for the sake of clarity of some features in the figures. For example, the thickness of metal layers 101 and 102 will usually be significantly smaller than the thickness of the substrate 105 in most cases. The skilled person will further note that even though the patch antenna 101 is shown in a circular profile in the figures, other shapes such as, square, triangular, semicircular, sectoral, annular ring shapes, and others shapes also fall within the ambit of the invention. Furthermore, as also commented previously, the patch antenna 101 and the ground plane 102 are normally realized in metal layers. Such layers are deposited, or formed, by a process such as deposition and/or lithography, or other suitable processes, over the substrate 105. These layers, i.e., the one for the patch antenna 101, and the one for the ground plane 102 are often of the same material.

In figures, for example, in Fig. 1 (B), the cross-sections of these layers are shown in different shading. This is done primarily for making it easier to correlate layers of similar functionality discussed in various aspects of the present teachings in this disclosure. It will further be appreciated that in this disclosure terms like top, bottom, downwards, are used in a relative sense and in relation to the orientation of the pictures shown in the figures for ease of understanding. Such terms do not limit the functionality or generality of the present teachings. The material of these layers, whether similar or not is not limiting to the scope of the invention as defined in the claims. It can also be mentioned that even though it may be apparent by looking at the figures that the ground plane covers the entire surface of the substrate side where the ground plane is placed, it may not necessarily be the case. It is also possible to place at least the other circuitry besides the ground plane, routed in the same metal layer as the ground plane is realized in. The size or area of the ground plane is usually related to the size and shape of the patch antenna. It is often desired to have the ground plane area extending beyond the footprint of the patch antenna especially for reducing back radiation. In cases where back radiation is actually desired, the ground plane size may be roughly of the same size as the patch antenna aligned over it. Such aspects of antenna design are known in the field..

It can further be mentioned that the spacing between the patch antenna and the ground plane in the present invention is usually arranged between around 5% and around 20% of the diameter of the patch antenna when the patch antenna has a circular shape. In case the patch antenna has another shape or pattern, a similar range with respect to a circle encompassing the periphery of the antenna shape may be used. In typical cases, the spacing is around 10% of the diameter of the patch antenna. Besides, the spacing may also be calculated, for example, based upon bandwidth requirements from the antenna, and may thus even be determined empirically or by experiments.

According to an aspect, in the antenna arrangement, the second substrate 202 is used only for providing the conducting ground plane 102. According to another aspect, the second substrate 202 is used also for mounting the other circuitry 111.

In either case, the second substrate 202 may be a low cost type, for example, a low-cost PCB such as FR4 type or other low-cost glass-reinforced epoxy laminates. As a result, only the first substrate 205 substrate of the patch antenna group requires to have microwave properties. Since the area of such a substrate is similar to the and area of the patch antenna 101, the overall cost of the substrate is appreciably reduced. Furthermore, the crucial feed arrangement 115 is relatively simplified and routing distance thereof is reduced as the microwave circuitry 110 does not utilize the metal layer that the ground plane 102 uses. This further means that the footprint of the microwave circuitry 110 may be further minimized, which also appreciably reduces the area required by the microwave circuitry 110 realized according to the present teachings.

Another advantage of the present teachings is that the patch antenna group may be realized as an independent module and placed at a suitable location on different kind of wireless products without demanding special requirements such a special PCB, or necessity to adapt PCB layout for the microwave circuitry. The requirements for a suitable location in simplest sense will be that it provides a ground plane and area for mounting the patch antenna group. The second substrate may even be a multilayered PCB with at least some of the other circuitry lying within the footprint of the patch antenna group. In this way, overall size of a wireless apparatus, using the antenna arrangement as proposed, may be reduced without significantly affecting the performance of the patch antenna group. In addition, when realized as an independent module, capable of being mounted on different kinds of PCBs and wireless products, the development costs may also be reduced, for example, by being able to reuse the same design of the patch antenna group.

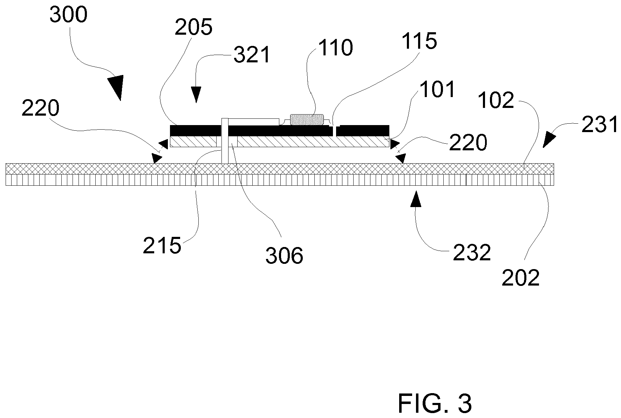

Yet another advantage of the present teachings is that the patch antenna group may be flipped either way. This is shown in Fig. 3 where a side view of an antenna arrangement 300 with a flipped patch antenna group is illustrated. In this case, on the top-side 321 of the first substrate 205, microwave circuitry 110 is mounted. The first feed 115 now traverses downwards from the microwave circuitry 110 to make electrical contact with the patch antenna 101 which is now arranged on the bottom-side of the patch antenna group. The second feed 215 now traverses through the patch antenna 101 to make electrical contact with the microwave circuitry 110 on the top-side 321. For electrically isolating the second feed 215 from the patch antenna 101, an opening 306 is provided into the patch antenna for the second feed 215 to pass through without contacting the patch antenna 101. The field lines 220 are also shown. Rest of the arrangement is essentially similar to that shown in Fig. 2.

A flexibility in terms of possibility to flip the patch antenna group means that the arrangement as most suitable in a given application may be selected. As an example, the arrangement of Fig. 3 may be more suitable in applications where it is desired to have the patch antenna 101 least exposed to other components around a package where the antenna arrangement is to be installed. The arrangement of Fig. 3 may also provide better flexibility in terms of adjusting antenna impedance in terms of adapting the distance between the patch antenna 101 and the ground plane 102.

As also described earlier, a skilled person will note that the spacing between the patch antenna group and the top-side 231 of the second substrate may either be an air-gap or even be a suitable material of desired dielectric constant. These aspects are flexible according to desired antenna properties and system requirements. The examples in this disclosure are shown in their simplest sense for ease of explanation.

The skilled person will also appreciate that the aspects and embodiments explained in this disclosure can be combined with each other to realize an antenna arrangement according to specific requirements. Discussion of an embodiment separately does not mean that an aspect of the teachings cannot be used with the rest of the examples or other embodiments presented herein.

To summarize, the present teachings relate to an antenna arrangement comprising, a patch antenna, a ground plane, at least some microwave circuitry, and a first substrate. The first substrate comprises a first surface and a second surface. The first surface and the second surface are opposite sides of the first substrate. The first surface and the second surface are essentially parallel to each another, with a separation essentially equal to the thickness of the first substrate. In other words, it can be said that the first surface and the second surface are the surfaces having the largest area in the first substrate. The patch antenna is realized in a first electrically conductive material attached to the first surface. The first electrical material is preferably a metal or it comprises at least partially a metal. The patch antenna is arranged with respect to the ground plane so as to form a resonant antenna. The term resonant antenna is well-known in the relevant technical field. Preferably the patch antenna is essentially parallel to the ground plane. Also preferably, the surface of the ground plane is centered with respect to the patch antenna surface. The microwave circuitry is mounted on the second surface. The microwave circuitry is operably connected to the patch antenna through a first feed. The surface area of the ground plane is preferably, but not essentially, greater than the surface area of the patch antenna. The antenna arrangement further comprises a second substrate. The second substrate comprises a third surface and a fourth surface. The third surface and the fourth surface are opposite sides of the second substrate. The third surface and the fourth surface are essentially parallel to each another, with a separation essentially equal to the thickness of the second substrate. The ground plane is realized in a second electrically conductive material attached to the third surface. The second electrical material is preferably a metal or it comprises at least partially a metal.

When referring to the surfaces or areas, especially of the conductive layers such as metal, a person skilled in the art understands which area and surface is meant when referring to such areas or surfaces. Since thickness of such layers is usually significantly smaller than the dimensions of the other exposed area when deposited on a surface, by saying the surface area, it is usually meant, the surface area essentially parallel to the essentially parallel surfaces of the substrate. With reference to the figures, the first surface corresponds for example, with the top-side 221 of the first substrate 205 shown in Fig. 2. The second surface corresponds to the surface on the other side, i.e., the surface where the microwave circuitry110 is shown mounted.

In one embodiment, the surface area of the ground plane is at least 1.5 times the surface area of the patch antenna. In a preferred embodiment, the surface area of the ground plane is essentially 2 times the surface area of the patch antenna.

Preferably, the first substrate is a microwave substrate.

Also preferably, the second substrate is a low-cost PCB such as FR4 type or other low-cost glass-reinforced epoxy laminate.

In one embodiment, the first surface is arranged to directly face the ground plane surface. Alternatively, the first surface is arranged to face away from the ground plane surface.

According to the invention the antenna arrangement also comprises a second feed. The second feed is operably electrically connected to at least the microwave circuitry or the patch antenna. Preferably, the second feed is used for feeding low frequency signals such as supply voltages and/or baseband signals to the microwave circuitry. The second feed is also be used for mechanically supporting and retaining the first substrate at least resiliently fixed with respect to the second substrate.

The present teachings also relate to a wireless unit comprising any one of the antenna arrangement embodiments or aspects discussed herein.

## Claims

1. An antenna arrangement comprising,
a patch antenna (101);
a ground plane (102);
microwave circuitry (110); and
a first substrate (205) comprising a first surface and a second surface, the first surface and the second surface being opposite sides of the first substrate (205), being essentially parallel,
the patch antenna being realized in a first electrically conductive material attached to the first surface, and the patch antenna being arranged with respect to the ground plane so as to form a resonant antenna;
the microwave circuitry (110) being mounted on the second surface of the first substrate (205), and the microwave circuitry being operably connected to the patch antenna through a first feed (115), wherein
the antenna arrangement further comprises a second substrate (202), said second substrate comprising a third surface and a fourth surface, the third surface being essentially parallel to the patch antenna (101), the third surface and the fourth surface being opposite sides of the second substrate (205), and the ground plane (102) being realized in a second electrically conductive material attached to the third surface (231) and the surface area of the ground plane being at least 1.5 times the surface area of the patch antenna, and wherein
the antenna arrangement comprises a second feed (215) connected the microwave circuitry (110) or the patch antenna (101), the second feed (215) also being in contact with the same conductive layer that the ground plane (102) is realized in and being electrically isolated from the ground plane, and
wherein the second feed (215) is also configured for mechanically supporting and retaining the first substrate (205) with respect to the second substrate (202).

2. Antenna arrangement according to claim 1, wherein at least the first electrically conductive material or the second electrically conductive material comprises at least partially metal.

3. Antenna arrangement according to any of the previous claims, wherein the first substrate (205) is a microwave substrate.

4. Antenna arrangement according to any of the previous claims, wherein the second substrate (202) is a low-cost PCB such as FR4 type or other low-cost glass-reinforced epoxy laminate.

5. Antenna arrangement according to any of the previous claims, wherein the first surface is arranged to directly face the ground plane (102) surface.

6. Antenna arrangement according to any of the claims 1 - 4, wherein the first surface is arranged to face away from the ground plane (102) surface.

7. Antenna arrangement according to any of the previous claims, wherein the patch is circular and the spacing between the patch antenna (101) and the ground plane (102) arranged to be between around 5% and around 20% of the diameter of the patch antenna, and preferably 10%.

8. Antenna arrangement according to claim 7, wherein the second feed (215) is configured to feeding low frequency signals such as supply voltages and/or baseband signals to the microwave circuitry (110).

9. A wireless unit comprising an antenna arrangement according to any of the previous claims.

## Patentansprüche

1. Antennenanordnung, umfassend
eine Patch-Antenne (101);
eine Grundebene (102);
eine Mikrowellenschaltlogik (110); und
ein erstes Substrat (205), umfassend eine erste Oberfläche und eine zweite Oberfläche, wobei die erste Oberfläche und die zweite Oberfläche gegenüberliegende Seiten des ersten Substrats (205) sind, die im Wesentlichen parallel sind,
wobei die Patch-Antenne in einem ersten elektrisch leitenden Material ausgeführt ist, das an der ersten Oberfläche angebracht ist, und die Patch-Antenne in Bezug auf die Grundebene angeordnet ist, sodass sie eine Resonanzantenne ausbildet;
wobei die Mikrowellenschaltlogik (110) auf der zweiten Oberfläche des ersten Substrats (205) montiert ist, und die Mikrowellenschaltlogik mit der Patch-Antenne durch eine erste Einspeisung (115) wirkverbunden ist, wobei
die Antennenanordnung ferner ein zweites Substrat (202) umfasst, das zweite Substrat umfassend eine dritte Oberfläche und eine vierte Oberfläche, wobei die dritte Oberfläche im Wesentlichen parallel zu der Patch-Antenne (101) ist, wobei die dritte Oberfläche und die vierte Oberfläche gegenüberliegende Seiten des zweiten Substrats (205) sind, und die Grundebene (102) aus einem zweiten elektrisch leitfähigen Material ausgeführt ist, das an der dritten Oberfläche (231) angebracht ist, und wobei der Oberflächenbereich der Grundebene mindestens das 1,5-fache des Oberflächenbereichs der Patch-Antenne beträgt, und wobei
die Antennenanordnung eine zweite Einspeisung (215) umfasst, die mit der Mikrowellenschaltlogik (110) oder der Patch-Antenne (101) verbunden ist, wobei die zweite Einspeisung (215) ebenfalls mit derselben leitenden Schicht in Kontakt steht, in der die Grundebene (102) ausgeführt ist, und von der Grundebene elektrisch isoliert ist, und
wobei die zweite Einspeisung (215) ebenso zum mechanischen Stützen und Halten des ersten Substrats (205) in Bezug auf das zweite Substrat (202) konfiguriert ist.

2. Antennenanordnung nach Anspruch 1, wobei mindestens das erste elektrisch leitfähige Material oder das zweite elektrisch leitfähige Material mindestens teilweise Metall umfasst.

3. Antennenanordnung nach einem der vorstehenden Ansprüche, wobei das erste Substrat (205) ein Mikrowellensubstrat ist.

4. Antennenanordnung nach einem der vorstehenden Ansprüche, wobei das zweite Substrat (202) eine kostengünstige Leiterplatte, beispielsweise vom Typ FR4, oder ein anderes kostengünstiges glasfaserverstärktes Epoxidlaminat ist.

5. Antennenanordnung nach einem der vorstehenden Ansprüche, wobei die erste Oberfläche angeordnet ist, um der Oberfläche der Grundebene (102) direkt zugewandt zu sein.

6. Antennenanordnung nach einem der Ansprüche 1 bis 4, wobei die erste Oberfläche angeordnet ist, um von der Oberfläche der Grundebene (102) abgewandt zu sein.

7. Antennenanordnung nach einem der vorstehenden Ansprüche, wobei der Patch kreisförmig ist und der Abstand zwischen der Patch-Antenne (101) und der Grundebene (102) angeordnet ist, um zwischen etwa 5 % und etwa 20 % des Durchmessers der Patch-Antenne und vorzugsweise 10 % zu betragen.

8. Antennenanordnung nach Anspruch 7, wobei die zweite Einspeisung (215) konfiguriert ist, um niederfrequente Signale, wie Versorgungsspannungen und/oder Basisbandsignale, an die Mikrowellenschaltlogik (110) zuzuführen.

9. Drahtlose Einheit, umfassend eine Antennenanordnung nach einem der vorstehenden Ansprüche.

## Revendications

1. Agencement d'antenne comprenant,
une antenne à plaque (101) ;
un plan de masse (102) ;
des circuits à micro-ondes (110) ; et
un premier substrat (205) comprenant une première surface et une deuxième surface, la première surface et la deuxième surface étant des côtés opposés du premier substrat (205), essentiellement parallèles,
l'antenne à plaque étant réalisée dans un premier matériau électriquement conducteur fixé à la première surface, et l'antenne à plaque étant agencée par rapport au plan de masse de manière à former une antenne résonante ;
les circuits à micro-ondes (110) étant montés sur la deuxième surface du premier substrat (205), et les circuits à micro-ondes étant connectés de manière opérationnelle à l'antenne à plaque par l'intermédiaire d'une première alimentation (115), dans lequel
l'agencement d'antenne comprend en outre un second substrat (202), ledit second substrat comprenant une troisième surface et une quatrième surface, la troisième surface étant essentiellement parallèle à l'antenne à plaque (101), la troisième surface et la quatrième surface étant des côtés opposés du second substrat (205), et le plan de masse (102) étant réalisé dans un second matériau électriquement conducteur fixé à la troisième surface (231) et l'aire de la surface du plan de masse étant au moins 1,5 fois l'aire de la surface de l'antenne à plaque, et dans lequel
l'agencement d'antenne comprend une seconde alimentation (215) connectée aux circuits à micro-ondes (110) ou à l'antenne à plaque (101), la seconde alimentation (215) étant également en contact avec la même couche conductrice que celle dans laquelle le plan de masse (102) est réalisé et étant électriquement isolée du plan de masse, et
dans lequel la seconde alimentation (215) est également configurée pour supporter et retenir mécaniquement le premier substrat (205) par rapport au second substrat (202).

2. Agencement d'antenne selon la revendication 1, dans lequel au moins le premier matériau électroconducteur ou le second matériau électroconducteur comprend au moins partiellement du métal.

3. Agencement d'antenne selon l'une quelconque des revendications précédentes, dans lequel le premier substrat (205) est un substrat à micro-ondes.

4. Agencement d'antenne selon l'une quelconque des revendications précédentes, dans lequel le second substrat (202) est un PCB à faible coût tel que de type FR4 ou un autre stratifié époxy renforcé de verre à faible coût.

5. Agencement d'antenne selon l'une quelconque des revendications précédentes, dans lequel la première surface est agencée de manière à faire directement face à la surface du plan de masse (102).

6. Agencement d'antenne selon l'une quelconque des revendications 1 à 4, dans lequel la première surface est agencée pour faire face à l'opposé de la surface du plan de masse (102).

7. Agencement d'antenne selon l'une quelconque des revendications précédentes, dans lequel la plaque est circulaire et l'espacement entre l'antenne à plaque (101) et le plan de masse (102) est compris entre environ 5 % et environ 20 % du diamètre de l'antenne à plaque, et est de préférence de 10 %.

8. Agencement d'antenne selon la revendication 7, dans lequel la seconde alimentation (215) est configurée pour alimenter des signaux à basse fréquence tels que des tensions d'alimentation et/ou des signaux en bande de base vers les circuits à micro-ondes (110).

9. Unité sans fil comprenant un agencement d'antenne selon l'une quelconque des revendications précédentes.
